# FASCICULE DE BREVET EUROPEEN

(11) **EP 2 864 718 B1**
(45) Date de publication et mention de la délivrance du brevet: **08.06.2016**
(21) Numéro de dépôt: 13727254.8
(22) Date de dépôt: 03.05.2013
(51) Int. Cl.: F24J 2/52

(54) **PROCÉDÉ D'INSTALLATION D'UNE STRUCTURE SOLAIRE SUR UNE PORTION DE SOL**
INSTALLATIONSVERFAHREN EINER SOLARSTRUKTUR AUF EINEM BODENABSCHNITT
METHOD OF INSTALATION OF A SOLAR STRUCTURE ON A PORTION OF GROUND

(30) Priorité: 22.06.2012 FR 1255956
(43) Date de publication de la demande: 29.04.2015
(73) Titulaire: Exosun, 33650 Martillac (FR)
(72) Inventeur: PAPONNEAU, François, F-33610 Cestas (FR)
(74) Mandataire: Novagraaf Technologies
(86) Numéro de dépôt international: PCT/FR2013/050995
(87) Numéro de publication internationale: WO 2013/190195

(56) Documents cités:
- WO-A1-2010/083292
- DE-A1-102010 024 546
- US-A1- 2011 186 040

## Description

L'invention concerne un procédé d'installation d'une structure solaire, en particulier une structure supportant un suiveur solaire, c'est-à-dire dont l'orientation change en fonction de la variation de l'ensoleillement durant la journée, voire durant l'année.

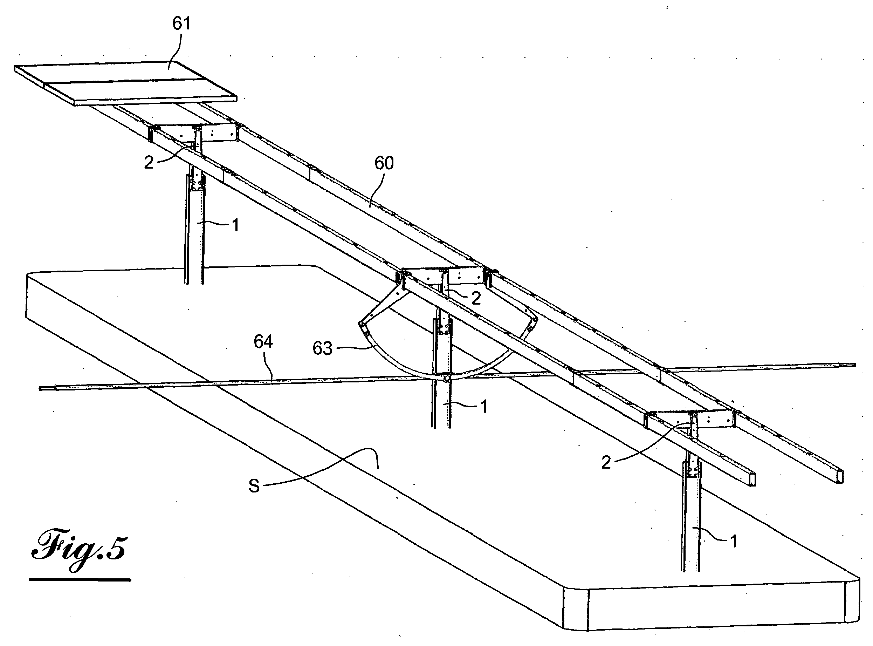

Communément, une structure solaire selon l'état de la technique, illustrée par exemple à la figure 5, comprend une ossature de support 60 qui permet de recevoir un ou plusieurs éléments de traitement du rayonnement solaire 61, par exemple une pluralité de cellules photovoltaïques. Les éléments de traitement, du rayonnement solaire 61 peuvent être montés fixes sur l'ossature 60. D'autre part, l'ossature 60 est montée de manière mobile à rotation sur un ensemble de pieds d'ancrage 1, eux-mêmes implantés dans un même alignement dans une portion de sol S, à l'aide de supports pivot 2. La structure solaire est orientée à l'aide d'un système d'actionnement 63,64 qui permet de contrôler l'inclinaison générale de l'ossature 60, donc des éléments de traitement du rayonnement solaire 61 par rapport au sol ou à la portion de sol S. Ici, l'ossature de support 60 est montée mobile à rotation sur trois pieds d'ancrage 1. C'est pourquoi il est important que la structure solaire soit parfaitement installée dans la bonne position afin que le contrôle de l'inclinaison générale de l'ossature de support 60, et donc des éléments de traitement du rayonnement solaire 61, ne soit pas faussé par un mauvais positionnement de ladite ossature de support 60.

Actuellement, afin de pouvoir parfaitement aligner les uns avec les autres, les axes pivots des supports pivot 2 au niveau de l'extrémité libre des pieds d'ancrage 1, des trous dans la portion de sol S sont réalisés afin de pouvoir y encastrer en partie les pieds d'ancrage 1. Des dispositifs d'étaiement sont positionnés au niveau de chacun des pieds d'ancrage et réglés de manière à les aligner avant de couler, dans les trous, du béton afin de maintenir de manière définitive les pieds dans leur position alignée. Toutefois, un tel procédé présente un double désavantage :
- un premier désavantage d'être long à mettre en oeuvre du fait de la mise en place des dispositifs d'étaiement sur chacun des pieds d'ancrage 1, d'une part, et, d'autre part, du fait de l'utilisation du béton qui nécessite un temps de séchage adéquat relativement long afin d'en assurer une prise correcte ;
- le deuxième inconvénient venant du béton lui-même qui a une masse volumique importante et. une rhéologie le rendant peu fluide. De ce fait, l'étape de coulage conduit à des problèmes de déstabilisation des pieds d'ancrage 1 dans leur position alignée et, ce, malgré les dispositifs d'étaiement. En conséquence, après le séchage de la masse de béton, l'ossature de support 60 est difficilement installable sur les supports pivot 2 ou bien avec un mauvais positionnement pouvant engendrer des erreurs d'inclinaison dans la commande de la structure solaire, ce qui engendre une dégradation du rendement des éléments de traitement du rayonnement solaire 61 supportés par l'ossature de support 60.

Le document D10 2010 024546 décrit un procédé d'installation d'une structure solaire sur une portion de sol pour assurer un positionnement et un alignement des supports pivot.

Un but de l'invention est de fournir un procédé d'installation d'une structure solaire qui soit simple, rapide à mettre en oeuvre tout en assurant un positionnement et surtout un alignement optimal des supports pivot destinés à recevoir l'ossature de support des éléments de traitement du rayonnement solaire.

A cet effet, il est prévu, selon l'invention, un procédé d'installation d'une structure solaire, comportant des étapes de :
a) implantation d'au moins deux pieds d'ancrage sur une portion de sol dans une position d'alignement ;
b) mise en place, au niveau d'une extrémité libre s'étendant au-dessus de la portion de sol de chacun des pieds d'ancrage, d'un support pivot comportant un axe de pivot ;
c) alignement des axes de pivot des supports pivot les uns avec les autres suivant une direction prédéterminée ;
d) fixation des supports pivot sur leur pied d'ancrage respectif ; et
e) mise en place de la structure solaire sur les supports pivot.

Ainsi, en réalisant l'alignement des axes pivots des supports pivot qui sont installés sur les extrémités libres des pieds d'ancrage préalablement positionnés de manière approximativement alignée permet d'orienter avant fixation lesdits supports pivot afin de rattraper les défauts d'alignement des pieds d'ancrage de manière simple, rapide et peu coûteuse.

Avantageusement, mais facultativement, le procédé d'installation selon l'invention comporte, en outre, au moins l'une des caractéristiques suivantes :
- l'étape d'alignement des axes de pivot s'effectue au moyen d'un outillage comportant un émetteur de rayons Laser et un ensemble de cibles ;
- l'étape de fixation des supports pivot s'effectue par vissage des supports pivot ;
- préalablement au vissage, le procédé comporte une étape de perçage d'orifices de fixation dans les pieds d'ancrage;
- le perçage d'orifices de fixation est réalisé concomitamment dans les supports pivot ;
- préalablement à l'étape de perçage, les supports pivot comportant des orifices de fixation, le procédé comprends des étapes de :
- marquage d'une position alignée des supports pivot sur leurs pieds d'ancrage respectifs à travers les orifices de fixation des supports pivot ; et,
- retrait des supports pivot de leurs pieds d'ancrage respectif ;
- suite à l'étape de perçage, le procédé comporte une étape de montage dés supports pivot sur leur pied d'ancrage respectif à l'aide des orifices de fixation préalablement percés ;
- le procédé comprend une étape de contrôle de l'alignement des axes de pivot des supports pivot avant l'étape de vissage ; et,
- l'étape de fixation des supports pivot s'effectue par soudage.

D'autres caractéristiques et avantages de l'invention apparaitront lors de la description ci-après d'un mode de réalisation préféré de l'invention. Aux dessins annexés :
- la figure 1 est une vue tridimensionnelle illustrant l'étape d'alignement des axes de pivots des supports pivot selon un procédé selon l'invention ;
- la figure 2 est une vue tridimensionnelle d'une extrémité libre d'un pied d'ancrage après réalisation d'orifices de fixation suite à l'étape d'alignement selon le procédé selon l'invention ;
- la figure 3 est une vue tridimensionnelle similaire à la figure 2 sur laquelle un support pivot 2 a été remonté sur le pied d'ancrage suite à la réalisation des orifices de fixation suivant le procédé selon l'invention ;
- la figure 4 est une vue tridimensionnelle de l'ensemble des supports pivot fixés sur leurs pieds d'ancrage respectifs juste avant la mise en place de la structure solaire selon le procédé selon l'invention ; et,
- la figure 5 est une vue tridimensionnelle d'une structure solaire installée selon le procédé selon l'invention.

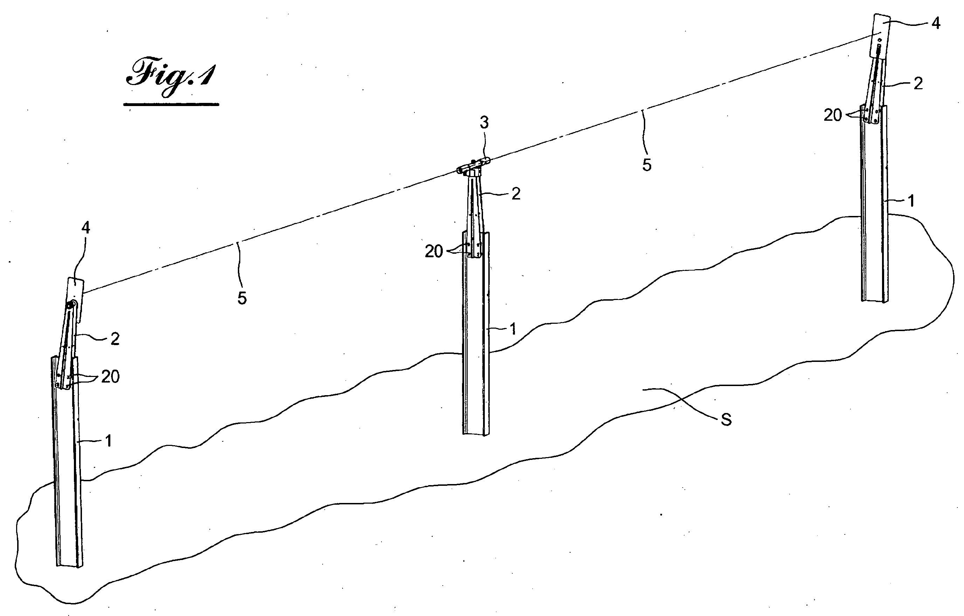

En référence à la figure 1, nous allons décrire les premières étapes d'un procédé d'installation d'une structure solaire selon l'invention. Dans un premier temps, au niveau d'une portion de sol S, une série de pieds d'ancrage 1 sont mis en place de manière sensiblement verticale et de manière sensiblement alignée selon une direction prédéterminée. La mise en place des pieds d'ancrage 1 de la série de pieds d'ancrage 1 s'effectue par battage. En variante, d'autres procédés de mise en place des pieds d'ancrages peuvent être utilisés (vissage, prise dans du béton...) Une fois mis en place dans la portion de sol S, chacun des pieds d'ancrage 1 présente une extrémité libre s'étendant au-dessus de ladite portion de sol S.

Dans une deuxième étape, un support pivot 2 est positionné au niveau de l'extrémité libre de chacun des pieds d'ancrage 1. Le support de pivot 2 est fixé de manière dite lâche sur l'extrémité libre du pied d'ancrage 1, c'est-à-dire que le support pivot 2 conserve une position donnée lorsqu'il n'est pas sollicité alors que toute sollicitation permet de déplacer ou de changer la position du support pivot 2 sur l'extrémité libre du pied d'ancrage 1. Une telle liaison peut être réalisée par un simple serrage à l'aide d'un serre-joint ou de tout autre outillage similaire, comme un système d'aimants. Il est à noter que les supports pivot 2 se présentent sous une forme allongée avec une première extrémité inférieure plus large qu'une extrémité supérieure, l'extrémité inférieure étant par exemple équipée, dès le départ, d'une série d'orifices de fixation 20, ici au nombre de quatre répartis aux quatre coins d'une figure rectangulaire, et l'extrémité supérieure comportant un orifice 21 dont l'axe forme un axe de pivot X du support pivot 2. En variante de réalisation, le support pivot 2 est remplacé par un gabarit simulant le support pivot.

Dans le cas illustré à la figure 1, trois pieds d'ancrage 1 ont été implantés dans la portion de sol S. Dans une étape suivante, un émetteur de rayon laser 3 est positionné à l'extrémité supérieure du support de pivot 2 de sorte à ce qu'un rayon laser émis le soit selon une direction perpendiculaire à un plan principal du support pivot 2, c'est-à-dire dans une direction parallèle à l'axe de pivot X du support de pivot 2. Des cibles 4 sont positionnées au niveau des extrémités supérieures des autres supports pivot 2 installés sur les deux autres pieds d'ancrage 1. Les cibles 4 comportent un repère qui, une fois les cibles positionnées sur l'extrémité supérieure du support pivot 2, se retrouvent dans la même position relative par rapport à l'axe de pivot X du support pivot 2 sur lequel la cible 4 est installée que la position relative du rayon laser émis par l'émetteur de rayon laser 3 par rapport à l'axe de pivot X de support du support de pivot 2 sur lequel ledit émetteur 3 est installé.

Dans une étape suivante, les supports pivot 2 sont positionnés de sorte à ce que les axes de pivot X de chacun des supports pivot 2 soient alignés les uns avec les autres. Pour cela, les supports pivot 2 sont déplacées de manière idoine par rapport à l'extrémité libre du pied d'ancrage 1. L'alignement est réalisé lorsque un rayon laser 5 émis par l'émetteur de rayon laser 3 frappe le repère réalisé sur chacune des cibles 4 positionnées de part et d'autre de l'émetteur de rayon laser 3, comme cela est illustré à la figure 1.

En variante, un cordeau peut être utilisé pour réaliser l'alignement en lieu et place de l'émetteur Laser et des cibles.

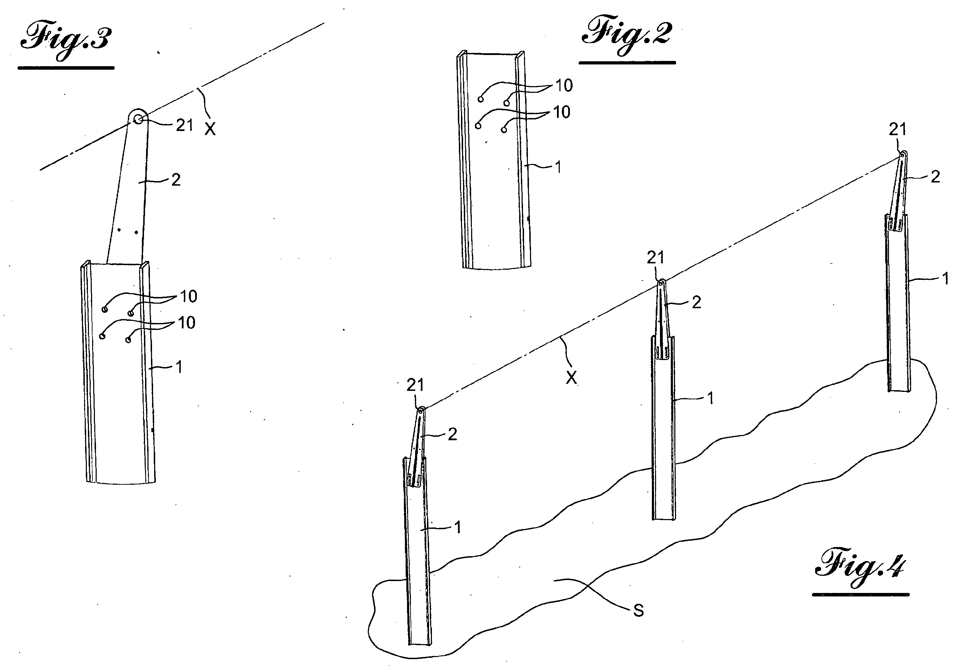

De là, dans une étape suivante, l'alignement souhaité étant obtenu, des orifices de fixation 10 sont réalisés dans l'extrémité libre de chacun des pieds d'ancrage 1 afin d'arriver à un résultat correspondant à celui de la figure 2. Les supports pivot 2 comportant des orifices de fixation 20 (ici au nombre de quatre), des orifices de fixation 10 sont réalisés dans l'extrémité libre de chacun des pieds d'ancrage 1 en regard des orifices de fixation 20 du support pivot 2 destiné à être reçu par ledit pied d'ancrage 1. Afin de réaliser le perçage des orifices de fixation 10 dans le pied d'ancrage 1, une fois l'alignement précédent réalisé, un marquage de la position des orifices de fixation 10 à réaliser est effectué par l'intermédiaire d'un pointeau par exemple à travers les orifice de fixation 20 du support pivot 2 associé. Ensuite, le support pivot 2 est retiré et les orifices de fixation 20 sont percés. Dans une variante de réalisation, le perçage des orifices de fixation 10 du pied d'ancrage 1 est réalisé directement à travers les orifices de fixation 20 du support pivot 2 associé maintenu en position suite à l'alignement précédemment décrit.

Une fois le perçage réalisé, les supports pivot 2 sont fixés de manière rigide, voire définitive, en position sur l'extrémité libre de leur pied d'ancrage 1 respectif. Pour cela, des moyens de fixation sont introduits dans chacun des orifices de fixation 20 du support pivot 2 et des orifices de fixation 10 du pied d'ancrage 1 correspondant. Ces moyens de fixation peuvent être des vis ou bien des boulons ou encore des rivets qui sont fermement serrés lors d'une étape finale, une fois l'alignement précédemment réalisé recontrôlé. Une fois le serrage final réalisé, les supports de pivot 2 ont leurs axes de pivot X alignés les uns avec les autres selon un même axe, comme cela est illustré à la figure 4.

En variante, afin d'éviter le recontrôle de l'alignement, les moyens de fixation sont agencées de sorte à être ajustés à la dimension des orifices de fixation 10, 20, assurant ainsi un repositionnement identique des supports pivot 2 sur leur pied d'ancrage 1 respectif au positionnement ayant permis le perçage de orifices de fixation.

Il ne reste alors plus qu'à monter la structure solaire sur les supports pivot 2 comme cela est illustré à la figure 5.

Dans une première variante de réalisation, les supports pivot 2 ne comportent pas d'orifices de fixation 20 réalisés préalablement au niveau de leurs extrémités inférieures. Dès lors, une fois l'alignement précédemment décrit réalisé, les orifices de fixation 20 du support pivot 2 et les orifices de fixation 10 du pied d'ancrage 1 sont réalisés simultanément par perçage de l'extrémité inférieur du support pivot 2 et de l'extrémité libre du pied d'ancrage 1.

Dans une autre variante de réalisation, en lieu et place des orifices de fixation 10 et 20 et de l'utilisation de moyens de fixation à travers ces orifices de fixation 10 et 20, l'extrémité inférieure du support pivot 2 est soudée sur l'extrémité libre du pied d'ancrage 1 en position une fois l'alignement précédemment décrit réalisé.

L'utilisation d'un procédé d'installation d'une structure solaire selon l'invention qui vient d'être décrit a pour avantage de permettre des tolérances d'implantation des pieds d'ancrage 1 dans la portion de sol S très larges tout en restant très précis dans l'alignement des axes de pivot X des différents supports pivot 2 installés au niveau de l'extrémité libre de chacun des pieds d'ancrage 1. Enfin, l'utilisation d'un procédé d'installation d'une structure solaire selon l'invention permet un tel alignement sur une série comportant deux ou plusieurs pieds d'ancrage 1 sans qu'il n'y ait de limitation au nombre de pieds d'ancrage 1 recevant un support pivot 2 de cette manière.

Bien entendu, il est possible d'apporter à l'invention de nombreuses modifications sans sortir du cadre de celle-ci.

## Revendications

1. Procédé d'installation d'une structure solaire (60,61), **caractérisé en ce que** le procédé comporte des étapes de :
a) implantation d'au moins, deux pieds d'ancrage (1) sur une portion de sol (S) dans une position d'alignement ; puis,
b) mise en place au niveau d'une extrémité libre s'étendant au-dessus de la portion de sol de chacun des pieds d'ancrage d'un support pivot (2) comportant un axe de pivot (X) ; puis,
c) alignement des axes de pivot (X) des supports pivot les uns avec les autres suivant une direction prédéterminée; puis,
d) fixation des supports pivot sur leur pied d'ancrage, respectif ; et puis
e) mise en place de la structure solaire sur les supports pivot.

2. Procédé d'installation selon la revendication 1, **caractérisé en ce que** l'étape d'alignement des axes de pivot s'effectue au moyen d'un outillage comportant un émetteur de rayons Laser (3) et un ensemble de cibles (4).

3. Procédé d'installation selon la revendication 1 ou 2, **caractérisé en ce que** l'étape de fixation des supports pivot s'effectue par vissage des supports pivot.

4. Procédé d'installation selon la revendication 3, **caractérisé en ce que**, préalablement au vissage, le procédé comporte une étape de perçage d'orifices de fixation (10) dans les pieds d'ancrage.

5. Procédé d'installation selon la revendication 4, **caractérisé en ce que** le perçage d'orifices de fixation (10) est réalisé concomitamment dans les supports pivot.

6. Procédé d'installation selon la revendication 4, **caractérisé en ce que**, préalablement à l'étape de perçage, les supports pivot comportant des orifices de fixation (20), le procédé comprends des étapes de :
- marquage d'une position alignée des supports pivot sur leurs pieds d'ancrage respectifs à travers les orifices de fixation des supports pivot ; et,
- retrait des supports pivot de leurs pieds d'ancrage respectif.

7. Procédé d'installation selon l'une des revendications 4 à 6, **caractérisé en ce que**, suite à l'étape de perçage, le procédé comporte une étape de montage des supports pivot (2) sur leur pied d'ancrage (1) respectif à l'aide des orifices de fixation (10) préalablement percés.

8. Procédé d'installation selon l'une des revendications 4 à 7, **caractérisé en ce que** le procédé comprend une étape de contrôle de l'alignement des axes de pivot des supports pivot avant l'étape de vissage.

9. Procédé d'installation selon la revendication 1 ou 2, **caractérisé en ce que** l'étape de fixation des supports pivot s'effectue par soudage.

## Patentansprüche

1. Verfahren zur Installation einer Solarstruktur (60, 61), **dadurch gekennzeichnet, dass** das Verfahren folgende Schritte aufweist:
a) Einbringen von mindestens zwei Füßen zur Verankerung (1) auf einem Bodenabschnitt (S) in einer Ausrichtungsposition; dann
b) Anbringen eines Schwenkträgers (2), welcher eine Schwenkachse (X) aufweist, im Bereich eines freien Endes eines jeden Fußes zur Verankerung, welches sich oberhalb des Bodenabschnitts erstreckt; dann
c) Ausrichten der Schwenkachsen (X) der Schwenkträger untereinander gemäß einer vorgegebenen Richtung; dann
d) Befestigen der Schwenkträger auf ihrem jeweiligen Fuß zur Verankerung; und dann
e) Anbringen der Solarstruktur an den Schwenkträgern.

2. Installationsverfahren nach Anspruch 1, **dadurch gekennzeichnet, dass** der Schritt zum Ausrichten der Schwenkachsen mittels von Werkzeug erfolgt, welches einen Laserstrahlemitter (3) und einen Satz von Targets (4) enthält.

3. Installationsverfahren nach Anspruch 1 oder 2, **dadurch gekennzeichnet, dass** der Schritt zum Befestigen der Schwenkträger durch Verschrauben der Schwenkträger erfolgt.

4. Installationsverfahren nach Anspruch 3, **dadurch gekennzeichnet, dass** das Verfahren vor dem Verschrauben einen Schritt zum Bohren von Befestigungslöchern (10) in die Füße zur Verankerung aufweist.

5. Installationsverfahren nach Anspruch 4, **dadurch gekennzeichnet, dass** das Bohren von Befestigungslöchern (10) gleichzeitig in den Schwenkträgern durchgeführt wird.

6. Installationsverfahren nach Anspruch 4, **dadurch gekennzeichnet, dass** vor dem Schritt zum Bohren der die Befestigungslöcher (20) aufweisenden Schwenkträger das Verfahren folgende Schritte umfasst:
- Markieren einer ausgerichteten Position der Schwenkträger auf ihren jeweiligen Füßen zur Verankerung durch die Befestigungslöcher der Schwenkträger; und
- Abnehmen der Schwenkträger von ihren jeweiligen Füßen zur Verankerung.

7. Installationsverfahren nach einem der Ansprüche 4 bis 6, **dadurch gekennzeichnet, dass** im Anschluss an den Schritt zum Bohren das Verfahren einen Schritt zum Montieren der Schwenkträger (2) auf ihrem jeweiligen Fuß zur Verankerung (1) mit Hilfe der zuvor gebohrten Befestigungslöcher (10) aufweist.

8. Installationsverfahren nach einem der Ansprüche 4 bis 7, **dadurch gekennzeichnet, dass** das Verfahren einen Schritt zum Kontrollieren der Ausrichtung der Schwenkachsen der Schwenkträger vor dem Schritt zum Verschrauben aufweist.

9. Installationsverfahren nach Anspruch 1 oder 2, **dadurch gekennzeichnet, dass** der Schritt zum Befestigen der Schwenkträger durch Verschweißen erfolgt.

## Claims

1. Method of installing a solar structure (60,61), **characterized in that** the method includes steps of:
a) implanting at least two anchor posts (1) on a ground portion (S) in an aligned position; then
b) placing a pivot support (2) having a pivot axis (X) at a free end of each of the anchor posts above the ground portion; then
c) aligning the pivot axes (X) of the pivot supports with one another in a predetermined direction; then
d) fixing the pivot supports to their respective anchor post; and then
e) placing the solar structure on the pivot supports.

2. Installation method according to Claim 1, **characterized in that** the step of aligning the pivot axes is effected by means of a tool including a laser emitter (3) and a set of targets (4).

3. Installation method according to Claim 1 or 2, **characterized in that** the step of fixing the pivot supports is effected by screwing on the pivot supports.

4. Installation method according to Claim 3, **characterized in that** the method includes before the screwing step a step of drilling fixing orifices (10) in the anchor posts.

5. Installation method according to Claim 4, **characterized in that** the fixing orifices (10) are drilled concomitantly in the pivot supports.

6. Installation method according to Claim 4, **characterized in that**, the pivot supports including fixing orifices (20), the method includes before the drilling step steps of:
- marking an aligned position of the pivot supports on their respective anchor posts through the fixing orifices of the pivot supports, and
- removing the pivot supports from their respective anchor posts.

7. Installation method according to any one of Claims 4 to 6, **characterized in that** the method includes after the drilling step a step of mounting the pivot supports (2) on their respective anchor post (1) using the fixing orifices (10) drilled beforehand.

8. Installation method according to any one of Claims 4 to 7, **characterized in that** the method includes before the screwing step a step of checking the alignment of the pivot axes of the pivot supports.

9. Installation method according to Claim 1 or 2, **characterized in that** the step of fixing the pivot supports is effected by welding.
